# EUROPÄISCHE PATENTANMELDUNG

(11) **EP 0 893 822 A2**
(43) Veröffentlichungstag der Anmeldung: **27.01.1999**
(21) Anmeldenummer: 98112471.2
(22) Anmeldetag: 06.07.1998
(51) Int. Cl.: H01L 21/56, H01L 21/48

(54) **Verfahren zum Einbetten von metallischen Leitern mikroelektrischer Bauelemente in eine Kunststoffmasse**

(30) Priorität: 22.07.1997 DE 19731424
(71) Anmelder: Daimler-Benz Aktiengesellschaft, 70567 Stuttgart (DE)
(72) Erfinder: Wartusch, Johann, 35246 Vellmar (DE); Merkel, Karl-Heinz, 67063 Ludwigshafen (DE); Rentsch, Arno, 65779 Kelkheim (DE)

(57) **Zusammenfassung**

Bei einem Verfahren zum Einbetten von metallischen Leitern mikroelektronischer Bauelemente in eine Kunststoffmasse, ist vorgesehen, daß die Oberfläche der einzubettenden Leiterbahnen durch physikalische und/oder chemische Verfahren aufgerauht wird und daß die Leiterbahnen im Bereich der Aufrauhung durch die Kunststoffmasse umschlossen werden.

## Beschreibung

Die Erfindung betrifft ein Verfahren zum Einbetten von metallischen Leiter mikroelektronischer Bauelemente in eine Kunststoffmasse nach dem Oberbegriff des Anspruchs 1.

Ein derartiges Verfahren dient zum Herstellen von Gehäusen, das Bauelemente und Module der Mikroelektronik enthält, wie monolithisch integrierte Schaltkreise, Multichipmodule und Hybride.

Integrierte Schaltkreise beispielsweise werden zur Montage und Kontaktierung der äußeren Anschlüsse auf einen sogenannten Leiterrahmen (lead frame) gebondet und anschließend in ein Gehäuse eingeschlossen. Insbesondere für SMD-Bauelemente oder Module mit vielen (mehr als 200) Anschlüssen bereitet die Kapselung der Bauelemente große Schwierigkeiten, vor allen Dingen im Zusammenhang mit den oft vorhandenen Kühlproblemen.

Normalerweise wird ein sogenannter IC, auf dem in integrierter Form eine Vielzahl von Funktionen realisiert ist, auf einem Basiselement (Leadframe) fixiert, welches zum IC, hin bzgl. Anordnung und Zahl der Anschlüsse entsprechende Kontakte aufweist, welche zur Peripherie hin mit entsprechenden Anschlüssen auf dem Substrat verbunden werden.

Die Anschlüsse auf den Bauelementen mit den entsprechenden Kontaktzungen des Leiterrahmens werden, wie im Falle eines einzelnen IC, in der Regel durch feine Drähte hergestellt, welche sowohl an den Bauelementen als auch an den Kontaktzungen durch Verschweißen (Bonden) befestigt werden. Beim Verschweißen müssen die Kontaktzungen des Leiterrahmens einen gewissen Druck aushalten. Die ganze Anordnung wird anschließend verschlossen bzw. mit Kunststoff umspritzt oder getaucht, damit Umwelteinflüsse sich auf die Schaltung nicht negativ auswirken können. Zum Schluß werden die Kontaktstifte auf ihre endgültige Form gebracht, d.h. die zungenförmigen Kontakte werden auf eine bestimmte Länge gebracht und für ein bestimmtes Sockelmaß zurechtgebogen.

Als gängiges Verfahren zur Umhüllung länger bekannt sind die Vollumkapselung der Bauelemente mit Duroplast-Moldmassen, die sich durch Hineinpressen in ein Werkzeug formen und in der Form aushärten lassen, sowie der Einbau in keramische Gehäuse und der Einbau in Metallgehäuse. Der Einbau in Keramik- oder Metallgehäuse gewährleistet eine beinahe hermetische Kapselung, verteuert jedoch die Komponenten so, daß die Anwendung für einen Massenmarkt nicht in Frage kommt. Bei Metallgehäusen kommt hinzu, daß wohl die Wärmebelastung der gekapselten Elemente sehr gut, die elektrische Isolierung jedoch sehr problematisch ist. Bei Keramikgehäusen hingegen ergibt sich speziell bei hochpoligen Elementen die Schwierigkeit, die Durchkontaktierung sehr filigraner Anschlußkämme durch das Gehäuse zu realisieren, wobei die Abstände zwischen den Anschlußzungen 300 µm betragen können.

Als preiswerteste Variante für kleinflächige Elemente und daher für große Stückzahlen geeignet ist zur Zeit lediglich die Vollumkapselung mit duroplastischen Werkstoffen. Die elektrischen Isoliereigenschaften sind hierbei naturgemäß sehr gut, die Wärmeableitung jedoch oft ungenügend. Nach dem bisherigem Stand der Technik werden z. B. in der Elektronik härtbare Massen, vorwiegend auf der Basis von Epoxidharzen, verwendet. Mit diesen Standard-Bauelementen wurden Kfz-übliche Dauertemperaturen von höchstens 125°C erreicht. Bei höheren Temperaturen besteht die Gefahr von Schädigungen infolge von Delaminationen, Rißbildung und feuchtigkeitsbedingter Korrosion, wodurch die zuverlässige Funktion der Bauelemente stark beeinträchtigt wird.

Die weiteren Nachteile solcher sog. Moldmassen, auch unter Kostengesichtspunkten, sind hohe Härtungstemperatur und lange Härtungszeiten (hoher Energieaufwand, Gefahr der thermischen Schädigung der elektronischen Bauteile), relativ hohe Wasseraufnahme, Umweltschädlichkeit wegen der Notwendigkeit flammhemmende Additive einzusetzen und fehlende Wiederverwendbarkeit.

Speziell bei großflächigen Strukturen für den Temperaturbereich bis 125° C ist bereits der Einsatz von speziellen Thermoplastgehäusen bekannt, die nicht mit einem reaktiven Transfer-Moldverfahren, sondern mittels Spritzguß gefertigt werden, insbesondere für Hybrid-Module. Diese sind jedoch vorerst nur mit wenigen Anschlußpolen realisiert, wobei ein Konstruktionswerkstoff wie z.B. Polybutylenterephtalat (PBT) mit integrierten Steckern verwendet wird. Das Gehäuse wird hierbei überlicherweise mit separat aufgeklebten Deckein verschlossen.

Die Erfindung geht aus von einem Gehäuse für Bauelemente der Mikroelektronik, wie es in der Patentschrift US 4,965,227 beschrieben ist. Dieses Gehäuse wird aus einem gießfähigen Kunststoff bzw. Thermoplast hergestellt. Die Zuleitungen zu den Bauelementen und die Kontaktstifte sind auf einer Trägerfolie befestigt, die der Isolation und Fixierung der als Leiterbahnen aufgebrachten Zuleitungen dient. Die Kontaktstifte werden an den vorgesehenen Stellen mit den Leiterbahnen verlötet. In einer Gießform, in der die Stifte positioniert werden, wird zunächst ein Untergehäuse hergestellt. In diesem Untergehäuse befindet sich eine Wärmesenke und ein Hohlraum, in welchem das Halbleiterbauelement positioniert wird. Der Hohlraum wird durch einen Deckel verschlossen, nachdem die Anschlüsse vom Bauelement zu den Leiterbahnen hergestellt worden sind.

Wegen der Lötung der Kontaktstifte ist allerdings eine Vergußmasse mit niedriger Verarbeitungstemperatur vorzuziehen. Bei Verarbeitungstemperaturen oberhalb von 200° C würde sich nämlich die Lötverbindung möglicherweise lösen. Aus diesem Grunde ist eine Kombination mit Hochtemperaturthermoplasten als Gehäusematerial problematisch.

Der Erfindung liegt die Aufgabe zugrunde, ein Verfahren zum Einkapseln mikroelektrischer Bauelemente in Verbindung mit einer Werkstoffkombination zur Grenzflächenverbesserung an der Stelle der Durchführung der Kontaktzungen durch das Gehäuse anzugeben, welches damit die Dauerstandfestigkeit und Dichtigkeit bei erhöhten Umgebungstemperaturen oberhalb von 120 ° C und in aggressiven, feuchten Medien verbessert.

Diese Aufgabe wird gemäß der Erfindung durch die im Anspruch 1 genannten Merkmale gelöst. Vorteilhafte Weiterbildungen sind in den Unteransprüchen enthalten.

Die Erfindung wird nachstehend anhand von Tabellen und Zeichnungen näher beschrieben.

Dabei zeigt:
Fig. 1 die Probe für Ziehversuche,
Fig. 2 das Gehäuse nach dem Spritzgießen,
Fig. 3 die Schälvorrichtung und
Fig. 4 verschiedene Ionenverfahren.

Verkapselte mikroelektronische Bauelemente finden Anwendung in der Nachrichten-, Energie- und Medizintechnik ebenso wie in der Luftfahrt- und Kfz-Elektronik. Besonders letztere stellen zunehmend höhere Anforderungen an Leistung und Zuverlässigkeit. Die höhere Zuverlässigkeit ist u. a. in einer besseren Dichtigkeit des eingehäusten Chips zu suchen, die im wesentlichen über höhere Haftfestigkeit der die metallischen elektronischen Durchführungen umschließenden Polymermatrix realisierbar ist (Haftung Interface Metall/Kunststoff).

Es wurden verschiedene Kunststoffklassen auf ihre Brauchbarkeit hin untersucht.

Neuere Epoxidharz-Reaktionsharze (Moldmassen) haben zwar Vorteile bezüglich etwas erhöhter Temperaturbeständigkeit (max. bis 180 °C) und wurden in die Untersuchungen mit einbezogen; die oben genannten Umweltprobleme sind jedoch noch ungelöst.

Auch sind die Epoxidharze Temperaturen von über 200° C nicht mehr gewachsen. Ihre Anwendungsgrenze liegt je nach Harzsystem und Beanspruchung zwischen 125 und 180° C. Oberhalb dieser Temperaturen beginnt bei diesen Harzen die thermische Zersetzung.

Weitere Nachteile der duromeren Materialien sind:
- lange Nachhärtezeiten nach dem Molden (Spritzpressen)
- relativ hohe Wasseraufnahme
- die Umweltschädlichket der flammhemmenden Additive
- nicht direkt wiederverwertbar

Hochtemperatur-Thermoplaste, nachfolgend nur noch HT-Thermoplaste genannt, bieten hierzu eine geeignete Alternative und erfüllen weitgehend die Anforderungen: hohe Dauertemperaturbeständigkeit, geringe Wasseraufnahme, Umweltneutralität, inhärente Flammwidrigkeit (z.B. ohne Zusatz halogenhaltiger Verbindungen Wiederverwertbarkeit und kurze (kostensparende) Verarbeitungszeiten durch Spritzgießen.

Für die Polymere als Einbettmaterialien der Bauelemente sind folgende Eigenschaften wünschenswert:
- Hohe Reinheit (Cl ≤ 2 ppm)
- Gute Fließfähigkeit
- Geringe Schrumpfung
- Lötbadbeständigkeit (20 sec./270°C)
- Temperaturbeständigkeit (180°C)
- Ausreichende Haftung
- Hohe Wärmeleitfähigkeit
- Geringe Wasseraufnahme (<0,8%, 24h/100°C)
- Geringe Ausgasung
- Chemische Beständigkeit gegen u.a. Kraftstoffe, Öle und Reinigungsmittel
- Temperatur- und mechanische Wechselbeständigkeit
- Inhärente Flammwidrigkeit
- Ultraschall-Schweißbarkeit (bei HT-Thermoplasten)
- Möglichkeit zur Wiederverwertung (Recycling)

Nach den beschriebenen Anforderungen wurden die Polymere ausgewählt. In die engere Auswahl kamen (außer den weiter unten beschriebenen Epoxidharzen) folgende HT-Thermoplaste:
- Polyethersulfon PES
- Polyarylethersulfon PAS
- Polyetherimid PEI
- Polyphthalamid PPA
- Polyaryletherketon PAEK
- Polyphenylensulfid PPS
- Flüssigkristallines Polymer LCP

Thermoplaste, wie z.B. Polycarbonat PC oder Polyamid PA, schieden wegen ihrer geringen Spannungsrißbeständigkeit bzw. hohen Feuchteaufnahme aus. Folgende Kriterien wurden besonders hoch bewertet: Verarbeitung, Metallhaftung, Lötbarkeit, DGT (Dauergebrauchstemperatur), Wasseraufnahme bzw. Systemkosten und Flammwidrigkeit

Die Verarbeitung wurde u.a. nach der Fließfähigkeit und der Verarbeitungstemperatur beurteilt. Die Metallhaftung wurde mit Hilfe von Zug-Scherversuchen (DIN 53 283) und Schälversuchen (DIN 53 289) geprüft.

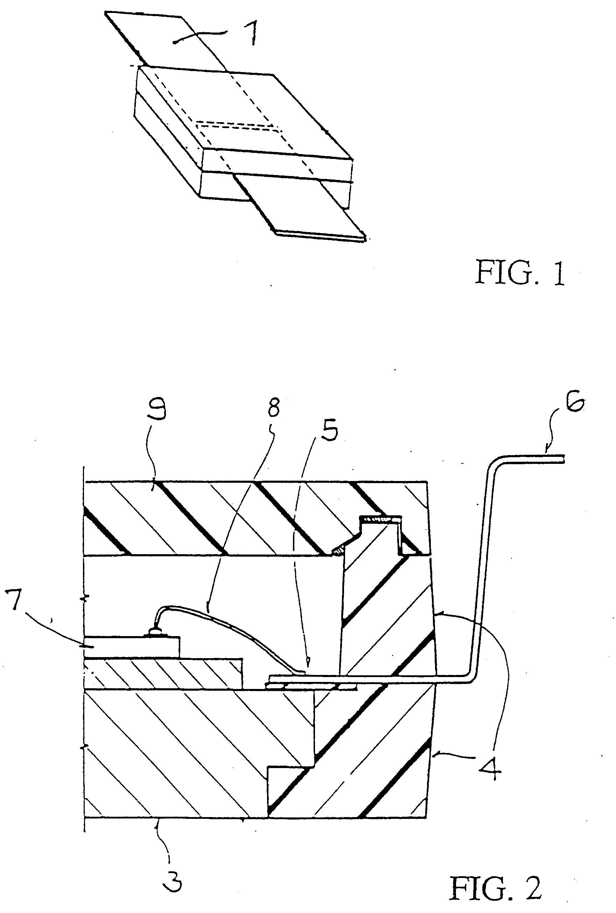

Für die Herstellung der Ausziehproben wurde eine speziell angefertigte Form verwendet. Es wurden zwei Plättchen in eine Form eingelegt und umspritzt. In Fig. 1 ist die grundsätzlich Anordnung der umspritzten zweiteiligen Probe 1 für die Versuche dargestellt. Die Plättchen sollen den Leadframes entsprechen und ihr Haftungsverhalten simulieren.

Für die Ausziehversuche wird die Probe an den beiden herausstehenden Plättchen gefaßt und auseinandergezogenen. Es soll das Ausziehen einzelner Beinchen simuliert werden. Übersteigt die Kraft die Haftfestigkeit, so wird ein Plättchen herausgezogen. Die Ausziehgeschwindigkeit betrug 2 mm/min. Die maximale Weglänge betrug 1 mm, bei einigen Proben 2 mm. Es wurde ein Diagramm Kraft-Weg aufgenommen. Die maximale Haftfestigkeit errechnet sich aus der maximalen Kraft und der umschlossenen Fläche des Plättchens.

Die Lötbarkeit wurde durch die Lötbadbeständigkeit in Anlehnung an DIN IEC 326 Teil 2 geprüft. Die Proben wurden 20 Sekunden in ein 270°C heißes Bad aus einer geschmolzenen Zinn-Blei-Legierung getaucht. Es wurde auf Gas- bzw. Wasserdampfentwicklung und Materialveränderung geprüft. Die Dauergebrauchstemperatur wurde durch Lagerung 2000 h bei 180°C überprüft. Die Wasseraufnahme wurde durch Lagerung 24 h in 100°C heißem Wasser geprüft. Die Ergebnisse sind in der folgenden Tabelle zusammengefaßt.

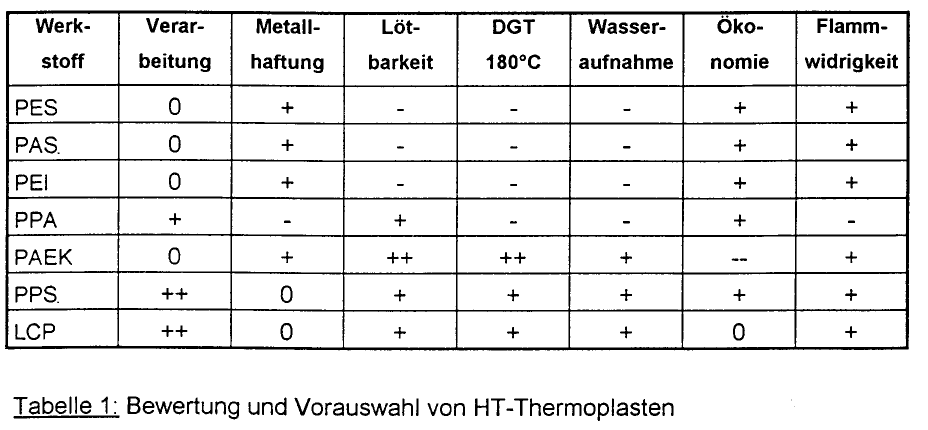

Für die HT-Thermoplaste wird wegen ihrer geringen Fließfähigkeit eine andere Einhäusungstechnik angewandt als für Duromere. Der Thermoplast wird nicht direkt als vollständig Umhüllung gespritzt, sondern es wird zunächst nur ein Rahmen bzw. eine Halbschale gespritzt (Premolden). Anschließend wird der Leadframe mit dem Chip bestückt, die Bonddrähte werden aufgebracht und zum Schluß wird ein Deckel mittels Ultraschall aufgeschweißt. Fig. 2 zeigt das Ergebnis der Einhäusungstechnik für Thermoplaste.

Der Leiterrahmen 6 ist mit dem Gehäuse 4 umspritzt. Der Chip 7 wird auf dem Boden 3 befestigt und mit Golddrähten 8 an dem Leiterrahmen bei 5 gebondet. Zum Schluß wird das Gehaüse mit dem Deckel 9 verschlossen. Ein Schutz gegen Feuchtigkeit ist nur durch eine ausreichende Haftung und vor allem Belastbarkeit der Grenzfläche Metall-Polymer gewährleistet. Auch die mechanische Belastbarkeit hängt von dieser Haftung ab.

Beim Spritzgießen wird der Werkstoff zuerst in die Schmelze und anschließend in eine beliebige Form im festen Zustand überführt. Dies geschieht mit Hilfe der Spritzgußmaschine, die im wesentlichen aus der Spritzeinheit, in der der thermoplastische Kunststoff plastifiziert wird besteht und der Schließeinheit in der sich das Formwerkzeug befindet.

Ein Spritzzyklus setzt sich also aus Einspritzzeit, Nachdruckzeit, Kühlzeit und gleichzeitiger Schneckenrotation, dem Entformen und einem eventuellen Neuanlegen der Düse, wenn diese nach der Nachdruckzeit vom Werkzeug abgezogen wurde, zusammen. Die nachfolgende Tabelle bringt einen Überblick über die wesentlichen Prozeßparameter, der Probekörper für die Messung der Haftungsfähigkeit.

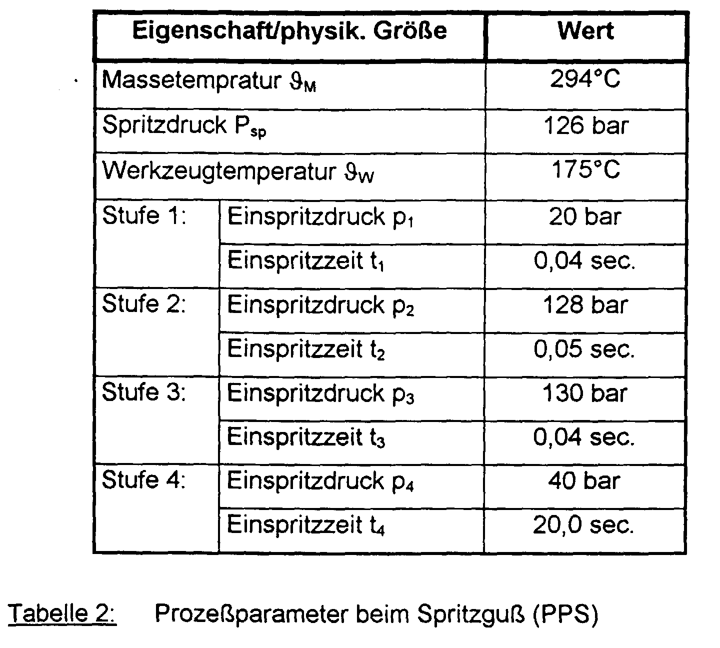

Der Grad der Kristallinität des PPS ist von der Werkzeugtemperatur abhängig. Je höher die Temperatur, desto höher ist auch der Kristallinitätsgrad. Eine maximale Kristallinität erhält man ab ca. 140°C. Die optimale Temperatur an der Werkzeugoberfläche beträgt aus spritztechnischen Gründen ca. 160°C. Die Füllung des Werkzeugs ist abhängig von der Einspritzgeschwindigkeit, dem Einspritzdruck, dem Nachdruck und der Nachdruckzeit. Diese Parameter müssen für das PPS für eine optimale Ausfüllung abgestimmt werden. Für das LCP besteht diese starke Abhängigkeit nicht. Aufgrund der sehr niedrigen Viskosität wird das Werkzeug auch ohne höhere Drücke ausreichend ausgefüllt.

Das Granulat sollte vor der Verarbeitung vorgetrocknet werden, um einen Molekulargewichtsabbau zu vermeiden. Die hohe Verarbeitungstemperatur kann zusammen mit der Feuchtigkeit zu einer Verringerung der Viskosität und der Festigkeit führen.

Die Massetemperatur sollte so weit erhöht werden, daß eine leichtere Füllung der Probenform aufgrund der niedrigen Viskosität erreicht wird.

Bei der Einhäusung von Bauelementen kommt es auf die bestmögliche Dichtigkeit des Gehäuses besonders an, da aggressive Medien die empfindlichen Bauelemente auf Dauer schädigen können. Die Haftung des thermoplastischen Materials auf den Kontaktzungen des Leiterrahmens (Leadframe) wird als für die Lösung dieses Problems entscheidend angesehen.

Die im Rahmen dieser Arbeit verwendeten 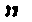 Leadframes" bestehen meist aus Cu-Legierungen die aus gewalzten Bändern geätzt oder bei großen Stückzahlen gestanzt werden. Sie dienen der Kontaktierung hochintegrierter Bauelemente mit Hilfe von Drahtbond-Verbindungen meist aus Al oder Au.

Die hier verwendeten Folien mit der Bezeichnung CuFe2P enthalten 2,1-2,6 Gew.% Eisen, Spuren von Phorsphor und Zink und fast 98 Gew.% Kupfer.

Diese Kupferlegierung ist ein Standard für die Mikroelektronik und besitzt eine hohe Leitfähigkeit und mittlere Festigkeit und eignet sich gut nach entsprechender Behandlung der Oberfläche für die gebräuchlichen Verbindungstechniken (Löten, Bonden, Kleben). Der Schmelzpunkt liegt bei über 1000°C. Eine ausreichende Wärmeleitfähigkeit ist vorhanden. Der lineare thermische Ausdehnungskoeffizient der Metalle liegt zwischen denen von Silizium als Chipwerkstoff und Kunststoff. Der Leadframe stellt somit einen Ausgleich zwischen den beiden Extremen dar. Das CuFe2P liegt mit seinem Ausdehnungskoeffizienten näher am Kunststoff. Damit soll die Auswirkung der unterschiedlichen Ausdehnungen vermieden werden.

Im folgenden werden die hier wichtigsten bekannten Verfahren der Oberflächenbehandlung vorgestellt.

Oberflächenbehandlungen werden durchgeführt, wenn dem ausgewählten Substratwerkstoff gewünschte Eigenschaften fehlen. Diese Eigenschaften sind durch Behandlung mit Strahlung oder energiereichen Teilchen und/oder das Aufbringen oder Abtragen von Schichten zu erzielen.

Bei den mechanischen Oberflächenbehandlungen ist besonders das Sandstrahlen zu nennen. Es ist eine leicht anzuwendende Methode, die einen guten Effekt erzielt. Die Oberfläche wird stark vergrößert und es kommt zusätzlich zu einem Verklammerungseffekt. Ein Nachteil des Sandstrahlens ist allerdings die schlechte Weiterverarbeitbarkeit. Auf den rauhen Oberflächen ist das Löten und Bonden sehr schwierig bis nicht durchführbar. Außerdem ist mit einem Verbleib von Strahlgut splitterförmiger Aluminium-Korund auf dem Leadframe zu rechnen, was erheblich stören kann.

Das Anätzen der Leadframes führt ebenfalls zu einer Aufrauhung der Oberfläche. Es sind diverse Ätzprozesse bekannt (trocken, naß, isotrop, anisotrop, im Plasma, chemisch usw.), die jeweils zur Erzeugung charakteristischer Strukturen geeignet sind.

Darüberhinaus gibt es verschiedene Verfahren, um Oberflächenbeschichtungen chemisch aufzubringen bzw. abzutragen.

Eine weitere Möglichkeit, eine Vergrößerung der Oberfläche zu erzeugen, ist das Oxidieren, wobei nadelförmige Strukturen senkrecht zur Oberfläche entstehen. Eine Variante davon ist das sog. "black oxide", bei dem Cu-Folien in einer Flüssigkeit (Kaliumnitrat, Natronlauge und Zusätze) bei 80 °C getaucht werden, um an der Oberfläche ein Cu II-Oxid (CuO) zu erzeugen. Eine andere Variante ist die anodische Oxidation, bei der die Folie als Anode in einem Elektrolyten beschichtet wird.

Oxide werden aufgebracht, um eine bessere Anbindung an das Leiterplattenbasismaterial bei Multilayern zu erzielen. Im vorliegenden Fall soll es genutzt werden, um die Haftfestigkeit allseitig gegenüber dem Gehäuseteil zu verbessern. Wahrscheinlich kommt es zu einer richtigen Bindung zwischen dem Polymer und dem Black Oxide, sowie zwischen dem Black Oxide und dem Metall. Versuche mit normalen Oxiden haben eine relativ gute Haftung zwischen den Oxiden und dem Kunststoff ergeben, aber die Anbindung zum Metall fehlte. Diese Anbindung kann durch den Prozeß des Schwarzoxidierens möglicherweise verbessert werden.

Vielfach werden die Schichten aufgedampft oder aufgesputtert. CVD-Chemical Vapour Deposition bedeutet chemische Abscheidung aus der Gasphase. Die abzuscheidenden Materialien befinden sich im gasförmigen Zustand. Mittels Energiezufuhr werden sie aktiviert, so daß sich auf der Substratoberfläche das gewünschte Reaktionsprodukt, eine feste Oberflächenschicht abscheidet. Zusätzlich entstehen flüchtige Reaktionsprodukte. Auch hier gibt es drei verschiedene CVD-Verfahren. Bei der thermischen CVD wird die Energiezufuhr durch Stöße an heißen Oberflächen übertragen. Bei der Plasma-CVD (PECVD) erfolgt die Anregung durch Elektronenstöße in der Glimmentladung. Als dritte Variante gibt es noch die Photo-CVD. Hierbei wird im Lichtbogen gearbeitet. Es können Schichten aus Metallen, Legierungen, Oxiden, Nitriden, Carbiden, Boriden oder Siliciden erzeugt werden.

Neben dem PVD/CVD-Verfahren eignen sich auch Ionenverfahren um Metalle zu beschichten bzw. deren Oberfläche zu modifizieren.

Verbesserungen der Haftfestigkeit konnten durch Modifikation der Oberfläche des metallischen Partners des sog. Leadframes oder Leiterahmens erzielt werden, indem zunächst sogen. 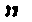 Treatments" aufgebracht werden. Sie wirken als Haftvermittler. Solche 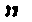 Treatments" sind prinzipiell bekannt und wurden bislang ausschließlich bei der Herstellung von Leiterplattenbasismaterial eingesetzt, um die Cu-Folie mit dem faserverstärkten Duroplast-Isoliermaterial (Harze) fest zu kaschieren.

Bei den Treatments handelt es sich um kommerziell erhältliche, spezielle Oberflächenschichten, die mit Hilfe eines Elektrolyten galvanisch auf üblicherweise Kupferfolien aufgebracht werden. Als "Treatments" bezeichnet man äußerst dünne (elektro-)chemisch hergestellte Oberflächenschichten, meist in Form von Mikrokristallen auf zerklüfteter Oberfläche. Die Schichten bestehen im Regelfall aus Kupfer/Kupferoxid und manchmal zusätzlich aus Messing bzw. Zink. Das Kupferoxid bildet sich häufig erst durch Reaktion mit der Luft auf der Oberfläche. Durch die Verfahrensweise ergibt sich eine spezifische Topografie der Metalloberfläche wie die sogenannte Blumenkohl- oder Champignon-Struktur, die durch ihre Hinterschneidungen zu einer wesentlich verbesserten Haftung durch mechanische Verankerung führt.

Bei der technischen Herstellung mechanisch/galvanischer Treatments für die Leiterplatten-Anwendung wird Elektrolyt-Kupfer aus einer Lösung auf eine Walze von 2,1 m Durchmesser und 2,4 m Breite aufgetragen, wobei die Walzenseite der Folie glatt ist, die Außenseite jedoch schon eine spezielle Rauhigkeit aufweist. Das Treaten erfolgt beim Banddurchlauf durch mehrere Elektrolytzellen, wobei zusätzlich in dünner Schicht (<< 1 µm) eine Kupferlegierung zur Haftungsverbesserung aufplattiert wird. Es können gezielt unterschiedliche Treatment-Feinstrukturen erzeugt werden. Diese Verfahren sind schon lange Zeit bekannt.

Entsprechend behandelte Proben können u.a. von der Firma Gould Electronics GmbH bezogen werden. Ein ähnliches Verfahren ist z. B. in der EP-OS 0 659 909 für Aluminium-Werkstoffe offenbart.

Treatments bestehen in den meisten Fällen aus demselben Metall wie die Trägerfolie selbst, also Cu, zuweilen auch als Legierung mit Zink oder aus Chromaten. In wenigen Fällen kommt auch eine Belegung mit organischem Material zur Anwendung. Dafür kommen beispielsweise Harze in Frage.

Bevorzugtes Trägermaterial für Treatments ist Kupfer. In Laborversuchen war auch die Herstellung eines Treatments auf CuFe2P erfolgreich. Auf veredeltem Bauelement-Material (NiPd) ist ein Treatment zur Zeit nicht möglich. Die Gesamtrauhigkeit nimmt durch die Behandlung mit den Treatments zu. Die Folien sind 18 bis 70 µm dick und haben je nach Typ unterschiedlich Rauhigkeiten. Die Haftfestigkeiten auf dem Basismaterial liegen im Bereich von 1,6 N/mm (feinrauhe Folien) und 2,2 N/mm (Standard). Vergleichsmessungen an feinrauhen Folien ergaben Werte bis 1,4 N/mm für Moldmasse bzw. 0,9 N/mm für HT-Thermoplaste. Unbehandelte glatte Kupferfolien haben keine nennenswerte Haftung (< 0,1 N/mm).

Neben den beschriebenen mechanisch/galvanischen Treatments gibt es noch die Silan-Treatments, die am Ende des Galvanik-Prozesses auf rauhe Folien durch Aufspritzen aufgetragen und zusammen mit dem Treatment bei 140 °C getrocknet werden. Die Haftungsverbesserung durch das Silanisieren auf Substraten wie Cyanatester, BT-Harz und mod. EP-Harzen beträgt ca. 20 %. Die so erzielten Fortschritte sind jedoch noch nicht zufriedenstellend.

Im Gegensatz zu der Herstellung von Treatments für die Leiterplattenanwendung ist für die Gehäusetechnik eine zweiseitige Schichtaufbringung erforderlich (Treatment allseitig). Hierzu ist eine Verfahrensänderung notwendig: Anstelle der 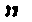 Walzentechnik" ist für eine allseitige Behandlung die Bad-Durchlauftechnik vorteilhaft.

Im Gegensatz zu den Treatments sind konventionelle galvanische Beschichtungen wie Gold, Silber oder Nickel-Palladium bereits im technischen Einsatz.

Die Nickel-Palladiumschicht wird aufgebracht, da sie sich gut löten und bonden läßt. Außerdem schützt sie den Leadframe vor Korrosion. Die Haftung auf ihr ist meist etwas geringer als auf blankem Material, und weitaus schlechter als auf Aluminium- oder Titanschichten. Die größere Bedeutung kommt daher den Treatments zu, auf denen die Erfindung aufbaut.

Für die Versuche wurden folgende Kupferfolien mit Treatment verwendet:

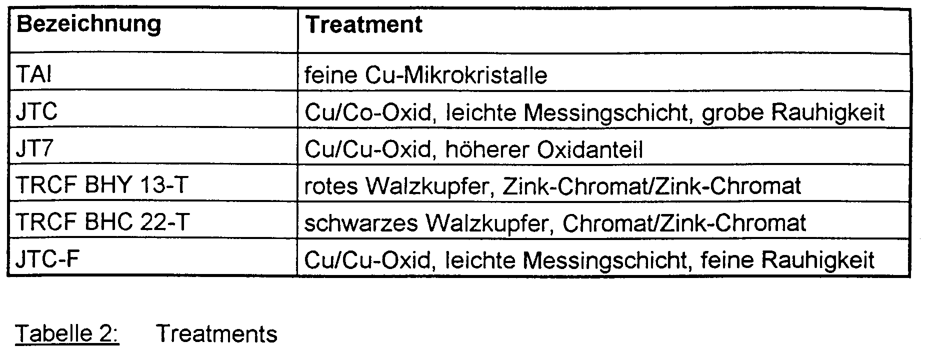

Die Prüfung der Haftfestigkeit erfolgte mittels Zugprüfmaschine:
a) einseitig: im Rollenschältest nach DIN 53289 und
b) allseitig: in einem Ausziehversuch.

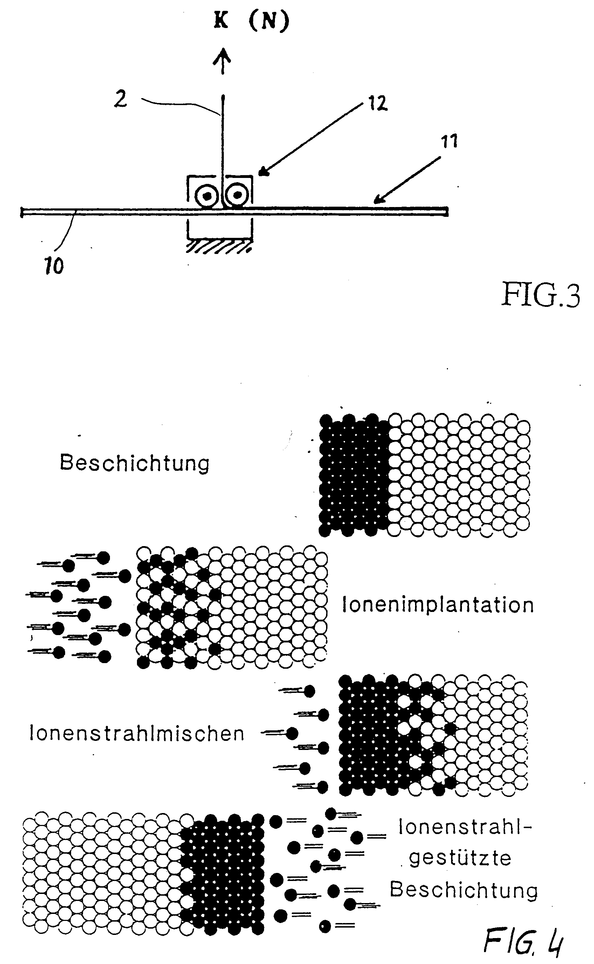

Die Rollenschälversuche wurden in Anlehnung an DIN 53 289 durchgeführt. Sie dienen zum Ermitteln des Widerstands von Metallklebungen gegen abschälende Kräfte. Als Prüfkörper wurden einseitig mit Cu-Folie kaschierte Parallelstreifen von 10 mm Breite sowie in Annäherung an die Praxis allseitig umspritzte idealisierte Test-Leadframes verwendet. Die verwendeten Schälvorrichtung ist in Fig. 3 dargestellt.

Die Proben 11 wurden zunächst an den Kanten abgeschliffen, um die Kupferfolien freizulegen. Bei der Probenherstellung war teilweise etwas Kunststoffmasse um die Folie herumgelaufen. Dadurch entstehen größere Haftkräfte, was die Ergebnisse verfälschen würde. An einem Ende wurde die Folie 11 meist durch Brechen der Probe von der Kunststoffmasse abgehoben und in die Schälvorrichtung 12 eingespannt. Die Schälvorrichtung ist im Gegensatz zur DIN-Norm etwas verändert. Die Folie2 wurde mit gleichbleibender Geschwindigkeit von der Kunststoffmasse 10 abgezogen. Der Schälwiderstand wurde in Abhängigkeit vom Weg in einem Diagramm aufgenommen. Der Schälwiderstand p errechnet sich aus der Trennkraft F in N und der Breite b der Probe in mm zu: P = F/b in N/mm. Nach dem Rollenschälversuch zeigt sich, daß mit den diversen Treatments unterschiedliche Schälwiderstände zu erreichen sind.

Zumindest hinsichtlich von Interface-Verbesserungen mit thermoplastischen Kunststoffen bestanden chemische und physikalische Vorbehalte gegen die Anwendung solcher "Treatments", da sie als hochmolekulare Polymere andere Benetzungseigenschaften gegenüber den bei der Aufbringung zunächst flüssigen stark polar aufgebauten duromeren Harzen haben. Es waren Vorurteile auch insofern zu überwinden, als nicht die Rauhtiefe die Haftfestigkeit allein bestimmt, sondern auch die spezielle Geometrie und Oberflächenbeschaffenheit. Dies zeigen die Maßzahlangaben in der folgenden Tabelle, welche die Versuche mit Epoxidharz wiedergeben.

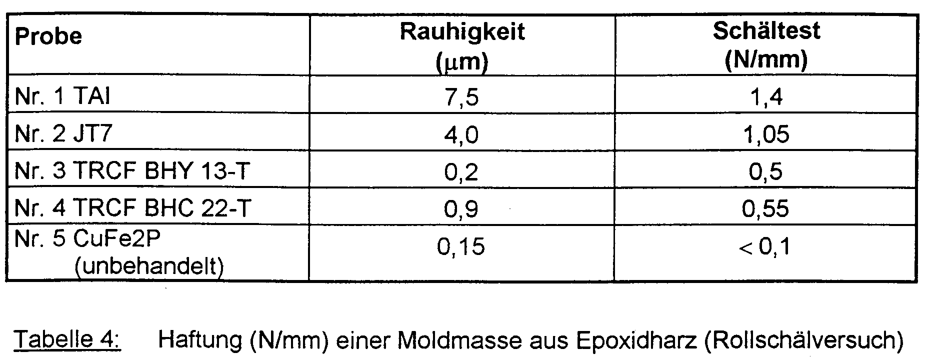

Der nur sehr begrenzte Einfluß der absoluten Größe der Rauhigkeit (r_{z}) ergab sich auch aus Strahlversuchen von Metallfolien mittels Korund (vgl. Tabelle 5).

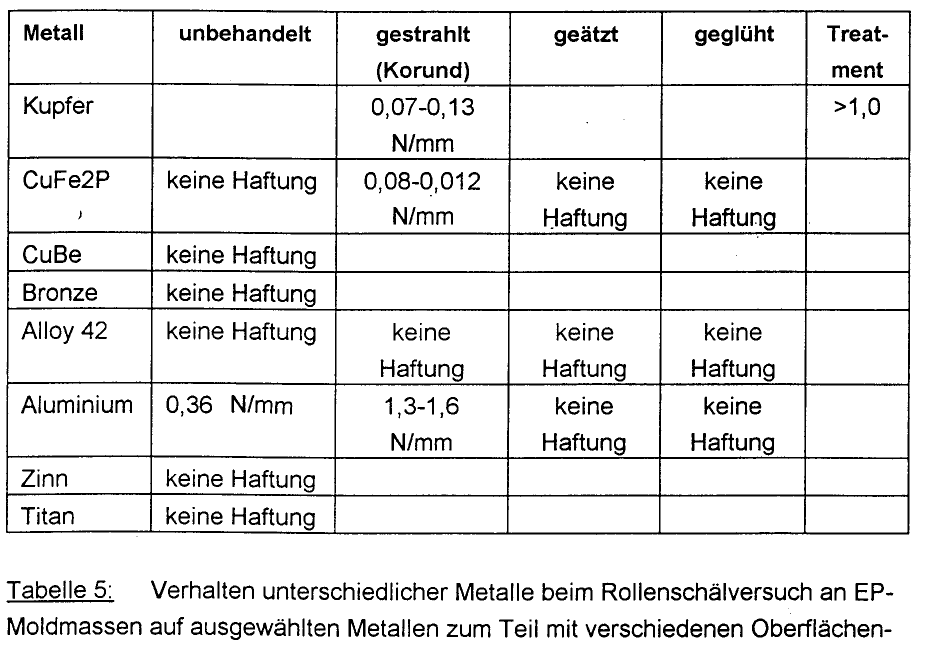

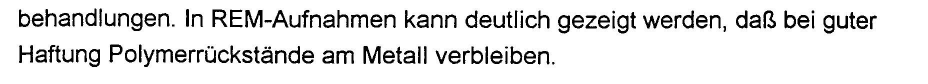

Die Probekörper für die Rollenschälversuche wurden durch Pressen hergestellt. Da dieses Verfahren für HT-Thermoplaste nicht günstig ist, wurden vergleichende Versuche für diverse Metalloberflächen mit Moldmasse durchgeführt. Im Rahmen weiterer Arbeiten wurde folgender Materialvergleich durchgeführt (Tab. 6).

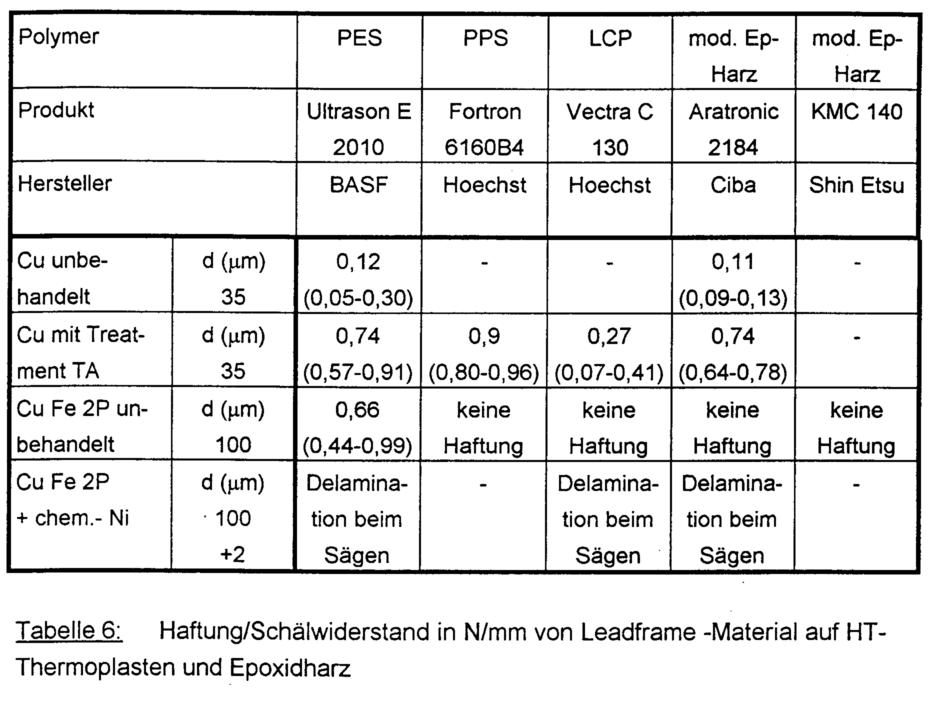

Die Haftfestigkeit, gemessen in N/mm², von HT-Thermoplasten, z. B. PPS und LCP, wurden vorwiegend praxisnah mittels des obengenannten Ausziehversuchs an voll umspritzten Leadframes aus CuFe2P ermittelt. Dabei werden Haftungsverbesserungen um den Faktor 6 - 10 gegenüber unbehandelten Oberflächen erzielt. Das geht für Proben aus PPS aus folgender Tabelle hervor:

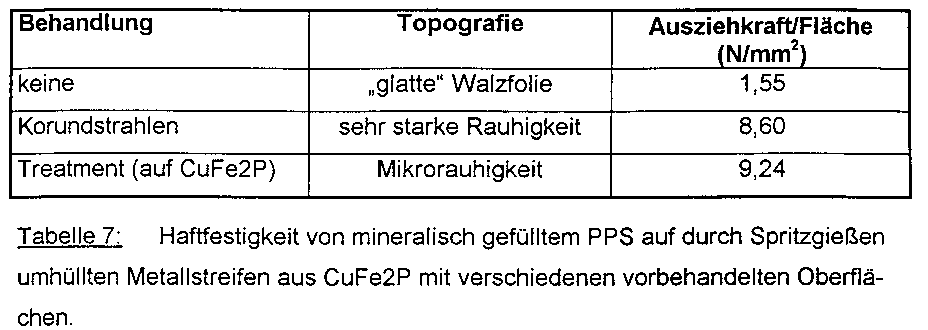

Die Tabelle 8 zeigt eine Übersicht über Ergebnisse der Ausziehversuche zur Bestimmung der Haftfestigkeit von PPS und LCP auf Treatments.

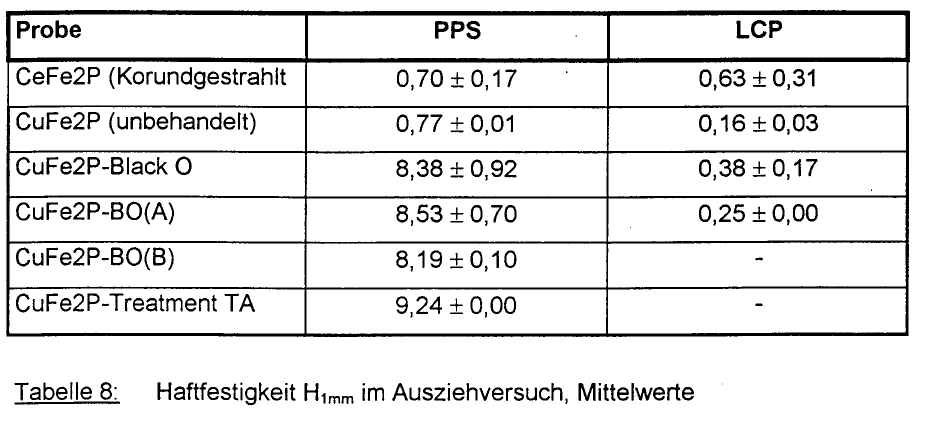

Für die beiden HT-Thermoplaste wurde als spezielles Treatment auch das sog. Black Oxide (BO) erprobt, das sich in allen Versuchen als vorteilhaft erwiesen hatte. Möglicherweise liegt dieser Vorteil in katalytisch-sorptiven Eigenschaften mancher Oxide begründet, die zu festen chemischen Bindungen führen können. Für LCP waren Treatments zur Haftungsverbesserung im Gegensatz zu PPS ungeeignet.

Aus den dargestellten Ergebnissen ist zu erkennen, daß gezielte Oberflächenbehandlungen mit dem sog. Treatment einen erheblichen Fortschritt darstellen können.

Neben den bisher beschriebenen Verfahren zur Oberflächenbeschichtung eignen sich auch Ionenverfahren um Metalle zu beschichten bzw. deren Oberfläche zu modifizieren.

Bei den Ionenverfahren muß zwischen drei unterschiedlichen Verfahrensvarianten unterschieden werden: Ionenimplantation, Ionenstrahlmischen und Ionenstrahlgestützte Beschichtung (IBAD)

Fig. 4 zeigt die verschiedenen Verfahrensvarianten in einer prinzipiellen Darstellung. Bei der Ionenimplantation werden die Ionen mit hoher Energie von typischerweise 60 bis einige 100 keV implantiert, wobei es zu Dotierungen bis ca. 10% an Fremdatomen kommen kann. Überlicherweise dringen diese Fremdatome bzw. Ionen einige µm in das Substrat ein; sie verbleiben also nicht an der Oberfläche. Damit ist zwar eine Modifikation vorhandener oberflächennaher Bereiche möglich, aber keine Erzeugung homogener Zwischenschichten, die die Haftung fördern könnten.

Eine Verbesserung läßt sich durch das Ionenstrahlmischen erreichen, bei dem die Ionen durch eine bereits vorgeformte Beschichtung hindurchgeschossen werden und im Grenzbereich zwischen Schicht und Substrat zur Ruhe kommen. Die Dicke der zu durchdringenden Beschichtung bestimmt die Ionenenergie (meist > 60 keV).

Bei der ionenstrahlgestützten Bedampfung (IBAD) wird durch Aufdampfen (oder Zerstäuben) eine Schicht aufgebracht und gleichzeitig mit einem Ionenstrahl beschossen. Durch geeignete Wahl der Verfahrensparameter sind sowohl die Schichteigenschaften (Eigenspannung, Porosität, Zusammensetzung) als auch die Haftung (Reinigung, Aufrauhung oder Benetzungseigenschaften der Substratoberfläche) veränderbar. Die Ionenenergie ist inder Regel niedriger als bei der Ionenimplantation oder dem Ionenmischen (≈ 10 keV). Dadurch ergeben sich im Vergleich zu diesem Verfahren weniger Durchmischungen im Bereich der Substratoberfläche.

Zur Schichterzeugung wurde folgendes Parameterfeld untersucht:

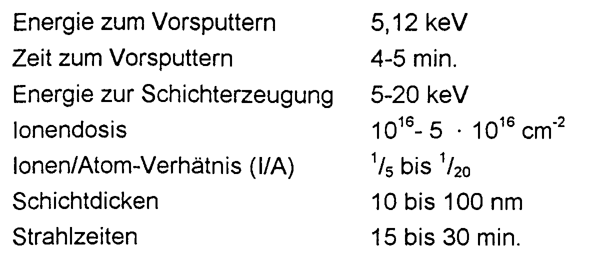

Es wurden mit den Metallen Al, Cr, Ti gearbeitet. So hergestellte Oberflächenschichten zeichnen sich durch eine gute Anbindung an Kunststoffe aus.

Die bevorzugte Ionenstrahltechnik ist der sogenannte IBAD-Prozess, weil damit die am besten definierten Grenzflächen herstellbar sind. Die Ergebnisse der so behandelten Proben zeigt Tabelle 9:

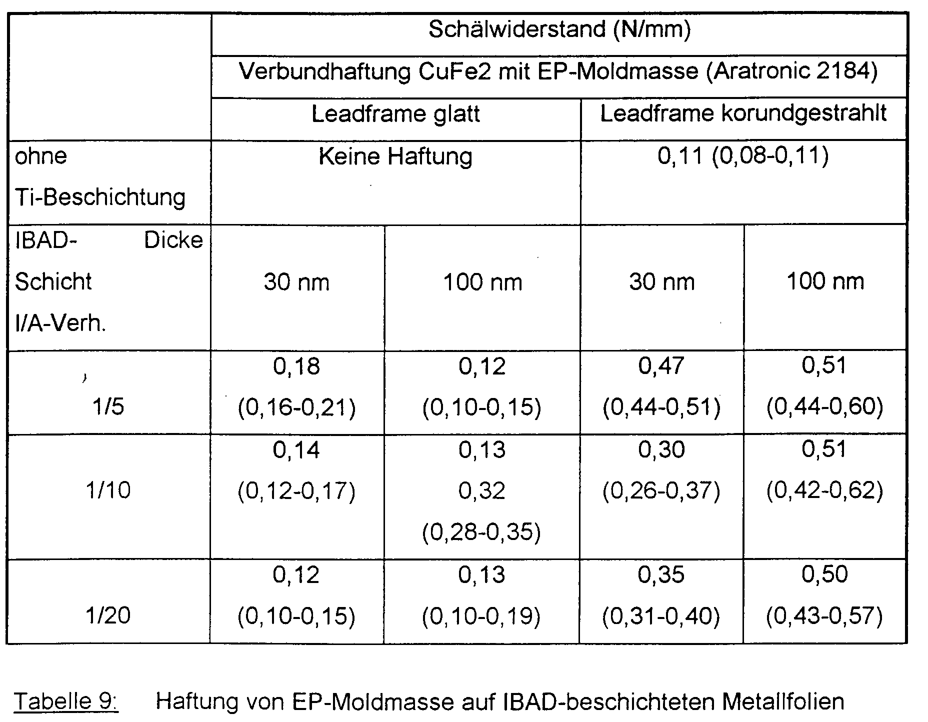

Auf unbehandelten (glatten) Cu Fe 2-Oberflächen sind durch IBAD-Beschichtungen aus Cr, Ti kaum nennenswerte Verbesserungen erzielt. Dagegen ergeben sich Verbesserungen auf korundgestrahlten (rauhen) Leitrahmen um den Faktor 5, wobei größere Schichtdicken der durch IBAD zusätzlich erzeugten Schichten von Vorteil sind. Dieser Zusammenhang ist in Tabelle 9 anhand der Meßwerte nachzuvollziehen. Es wird deutlich, daß die Rauhigkeit auch als Grundlage von Haftungsverbesserungen von großer Bedeutung ist. Weitere Einflüsse der IBAD-Prozessparameter waren bisher nicht nachweisbar. Die folgende Tabelle 10 zeigt das Ergebnis des Beschusses mit Titan-Ionen. Während man ohne Titan-Beschichtung einen Schälwiderstand von 0,11 N/mm beobachtet, ist im Mittel bei Titan-Beschichtung der Schälwiderstand um den Faktor 5 höher und relativ unabhängig vom Verhältnis der Ionen zu den Atomen (I/A).

Außer mit Titan-Ionen wurden die gleichen Experimente mit Chrom- und Aluminium-Ionen durchgeführt. Es ergab sich ein im Mittel um 25% höherer Schälwiderstand bei dem Beschuß mit Titan-Ionen. Da sich beim Beschuß mit Aluminium-Ionen Schwierigkeiten einstellten, wurden die Ergebnisse nicht weiterverfolgt, obwohl vieles darauf hindeutet, daß Aluminium noch höhere Werte des Schälwiderstands liefern kann.

Eine vorteilhafte Ausgestaltung der Erfindung besteht darin, die Kombination von Treatment und speziell ausgesuchten Kunststoffen als Grundlage für die Verbesserung der Haftfestigkeit und des Schälwiderstands durch Ionen-Beschuß zu verwenden. Mit dem speziellen Treatment, auf dem sich auf der Oberfläche kristallines Kupfer abgeschieden hatte (TA) wurde sowohl beim Hochtemperatur-Thermoplast PES als auch bei einer Epoxid-Moldmasse eine deutliche Haftungssteigerung gegenüber den nicht mit Ionen behandelten Proben gefunden. Die IBAD-Schichten aus Ti sowie Ti + TiC erbrachte Verbesserungen um den Faktor 2 - 3. Insbesondere die Beschichtung mit TiC war besonders 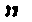 polymerfreundlich".

Die Durchführbarkeit der Prüfung hat zwei Voraussetzungen
- gute Affinität und Benetzbarkeit der Polymerschmelze zur IBAD-Schicht
- polymergerechte Verarbeitung (insbesondere muß der Druck während der Abkühlzeit aufrecht erhalten werden).

Bei teilkristallinen Hochtemperaturthermoplasten ist die polymergerechte Verarbeitung sehr schwierig, wenn die Proben nicht im Spritzgußverfahren, sondern durch Pressen hergestellt werden.

Die Ergebnisse der Rollenschälversuche mit verschiedenen Schichtkombinationen und verschieden ausgewählten Polymere ist in der Tabelle 10 zusammengefaßt.

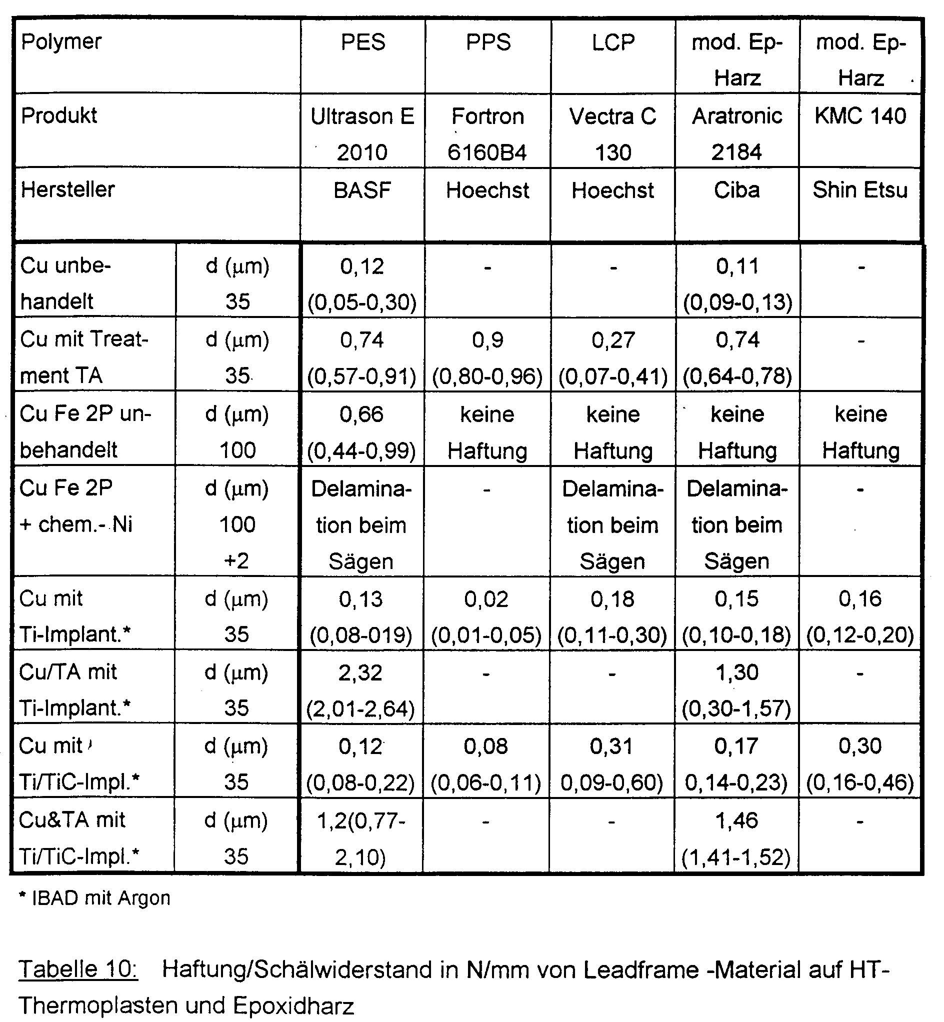

Die Ergebnisse ohne IBAD sind bereits aus der Tabelle 6 bekannt. Sie sind hier nur zum Vergleich noch einmal wiederholt.

Die Ergebnisse sind insofern etwas überraschend, als trotz sehr rauher Oberfläche, mit teilweise Hinterschneidungen und pilzförmigen Strukturen (Dendrite) das Beschießen mit Ionen noch eine deutliche Steigerung der Haftfestigkeit der ausgewählten Thermoplaste und Moldmassen erbringt.

Zum Löten der Anschlüsse benötigt man eine gute Benetzung der Oberfläche mit Lötpaste. Bei einer sehr rauhen Oberfläche kann es bei einer relativ hohen Oberflächenspannung der Flüssigkeit zu einer nicht vollständigen Benetzung kommen. Es sind dann nur wenige Kontaktpunkte für das Lot vorhanden, die Verbindung ist nicht ausreichend. Für den Bondprozeß gilt ähnliches. Um löten und bonden zu können, werden verschiedene Schichten wie Nickel-Palladium, Gold, Zinn, Blei-Zinn oder andere Schichten aufgebracht. Sie werden häufig selektiv aufgebracht, um Material zu sparen. Die verwendeten Bonddrähte sind Feinstdrähte mit Durchmessern von 17,5 µm bis 500 µm aus verschiedenen Metallen und Legierungen, die für elektrisch leitende Verbindungen vom Chip zum inneren Anschlußpad der Gehäuse sorgen. Hierbei wird der Bonddraht (häufig aus Gold) entweder auf den Leadframe aufgeschweißt oder der Draht wird aufgeschmolzen und dann mit der Oberfläche verbunden. Hier ist ebenfalls eine ausreichende Benetzung wichtig. Bei den Treatments kommt die Oxidschicht als Störfaktor für den Bond- und Lötprozeß hinzu. Beim Black Oxide könnte die Oxidschicht ebenfalls störend wirken.

Etwa auftretende Schwierigkeiten ließen sich durch selektives Treaten beheben. Nur die nachher umspritzte Fläche wird mit dem Treatment versehen. Andere Flächen könnten dann leichter selektiv mit löt- und bondbaren Schichten versehen werden, weil die Rauhigkeit der Oberfläche dort niedrig gehalten werden kann.

## Patentansprüche

1. Verfahren zum Einbetten von metallischen Leitern mikroelektronischer Bauelemente in eine Kunststoffmasse,
**dadurch gekennzeichnet,**
daß die Oberfläche der einzubettenden Leiterbahnen durch physikalische und/oder chemische Verfahren aufgerauht wird und daß die Leiterbahnen im Bereich der Aufrauhung durch die Kunststoffmasse umschlossen werden.

2. Verfahren nach Anspruch 1,
dadurch gekennzeichnet,
daß die Oberfläche im aufgerauhten Bereich vor der Umschließung durch die Kunststoffmasse mit Ionen bestrahlt wird.

3. Verfahren nach Anspruch 2,
dadurch gekennzeichnet,
daß die Ionenbestrahlung mit Aluminium- und/oder Titan- und/oder Chrom-Ionen oder Mischungen oder Verbindungen davon durchgeführt wird.

4. Verfahren nach Anspruch 1 oder 2,
dadurch gekennzeichnet,
daß die Kunststoffmasse ein Hochtemperatur-Thermoplast ist.

5. Verfahren nach Anspruch 1 oder 2,
dadurch gekennzeichnet,
daß die Kunststoffmasse ein Duroplast ist.

6. Verfahren nach Anspruch 1 oder 2,
dadurch gekennzeichnet,
daß die Kunststoffmasse eine Vergußmasse ist.

7. Verfahren nach einem oder mehreren der vorangegangenen Ansprüche,
dadurch gekennzeichnet,
daß die metallischen Leiter durch Bänder aus einem Metall auf Kupferbasis gebildet werden.

8. Verfahren nach Anspruch 7,
dadurch gekennzeichnet,
daß die Kupferfolien vorgestanzt oder vorgeätzt und an den zum Bonden oder Löten vorgesehenen Stellen vor dem Erzeugen der Hinterschneidungen mit einem Abdecklack beschichtet werden.

9. Verfahren nach einem oder mehrerer der vorangegangenen Ansprüche,
dadurch gekennzeichnet,
daß die Aufrauhung mit zusätzlichen Hinterschneidungen elektrochemisch erzeugt wird.

10. Verfahren nach einem der Ansprüche 1 bis 8,
dadurch gekennzeichnet,
daß die Hinterschneidungen chemisch erzeugt werden.

11. Verfahren nach einem der Ansprüche 1 bis 8,
dadurch gekennzeichnet,
daß die Hinterschneidungen durch Trockenätzen erzeugt werden.

12. Verfahren nach einem der Ansprüche 1 bis 8,
dadurch gekennzeichnet,
daß die Hinterschneidungen durch Abdrucktechnik erzeugt werden.

13. Anwendungen des Verfahrens nach Anspruch 1 zum Umschließen von durch ein Kunststoffgehäuse nach außen geführten Leiterbahnen.

14. Verfahren nach Anspruch 4,
dadurch gekennzeichnet,
daß als Hochtemperatur-Thermoplast Polyphenylensulfid (PPS) verwendet wird.

15. Verfahren nach Anspruch 4,
dadurch gekennzeichnet,
daß als Hochtemperatur-Thermoplast Liquid Crystal Polymer (LCP) verwendet wird.
